# EUROPÄISCHE PATENTANMELDUNG

(11) **EP 4 354 217 A1**
(43) Veröffentlichungstag der Anmeldung: **17.04.2024**
(21) Anmeldenummer: 22201560.4
(22) Anmeldetag: 14.10.2022
(51) Int. Cl.: G02F 1/35, G02F 1/355, G02F 1/39

(54) **STRAHLUNGSQUELLE UND VERFAHREN ZUM ERZEUGEN ELEKTROMAGNETISCHER STRAHLUNG MIT EINER MEHRZAHL VON FREQUENZEN**

(71) Anmelder: Hübner GmbH & Co. KG, 34123 Kassel (DE); Fraunhofer-Gesellschaft zur Förderung der angewandten Forschung e.V., 80686 München (DE)
(72) Erfinder: Dr. Kießling, Jens, 79110 Freiburg (DE); Dr.Schubert, Maik-Hendrik, 37075 Göttingen (DE); Wenderoth, Marius Horst Jürgen, 34117 Kassel (DE); Dr. Hens, Korbinian, 22765 Hamburg (DE)
(74) Vertreter: WSL Patentanwälte Partnerschaft mbB

(57) **Zusammenfassung**

Die vorliegende Erfindung betrifft eine Strahlungsquelle zum Erzeugen elektromagnetischer Strahlung mit einer Mehrzahl von Frequenzen, wobei die Strahlungsquelle eine Anfangsquelle, einen nichtlinear optischen Frequenzkonverter, einen Konversionsdetektor und eine Steuerung aufweist. Die Steuerung ist derart eingerichtet, dass wobei die Steuerung derart eingerichtet ist, dass sie in dem Betrieb der Strahlungsquelle in einem ersten Betriebsmodus das Konversionssteuersignal in Abhängigkeit von dem Konversionsmesssignal derart erzeugt, dass die Resonanzfrequenz so geregelt ist, dass sie der Anfangsmittenfrequenz folgt. Ergänzend sieht die Erfindung vor, dass die Steuerung in dem Betrieb der Strahlungsquelle auswählbar zwischen dem ersten Betriebsmodus und einem zweiten Betriebsmodus umschaltbar ist. Dabei ist die Steuerung derart eingerichtet, dass sie in dem zweiten Betriebsmodus das Konversionssteuersignal derart erzeugt, dass die Leistung der konvertierten Strahlung so geregelt ist, dass enteder die Leistung der konvertierten Strahlung eine geringere relative zeitliche Schwankung aufweist als die Leistung der Anfangsstrahlung in der Strahlrichtung vor dem Einkoppelspiegel oder die Leistung der Anfangsstrahlung in der Strahlrichtung nach dem Einkoppelspiegel eine geringere relative zeitliche Schwankung aufweist als die Leistung der Anfangsstrahlung in der Strahlrichtung vor dem Einkoppelspiegel.

## Beschreibung

Die vorliegende Erfindung betrifft eine Strahlungsquelle zum Erzeugen elektromagnetischer Strahlung mit einer Mehrzahl von Frequenzen, wobei die Strahlungsquelle eine Anfangsquelle, einen nichtlinear optischen Frequenzkonverter, einen Konversionsdetektor und eine Steuerung aufweist. Dabei ist die Anfangsquelle derart eingerichtet, dass sie in einem Betrieb der Strahlungsquelle elektromagnetische Anfangsstrahlung mit einer Anfangsmittenfrequenz erzeugt. Der nichtlinear optische Frequenzkonverter, beispielsweise ein optisch parametrischer Oszillator, weist einen für die Anfangsstrahlung resonanten Konverterresonator mit einem für die Anfangsstrahlung teilweise transparenten Einkoppelspiegel und einen in dem Konverterresonator angeordneten nichtlinear optischen Kristall auf. Der Frequenzkonverter ist in einem Strahlengang der Anfangsstrahlung angeordnet, so dass in dem Betrieb der Strahlungsquelle die Anfangsstrahlung durch den Einkoppelspiegel in den Koverterresonator eingekoppelt wird. Der Frequenzkonverter ist derart eingerichtet, dass er in dem Betrieb der Strahlungsquelle aus der Anfangsstrahlung konvertierte Strahlung mit einer konvertierten Frequenz erzeugt, wobei die konvertierte Frequenz von einer Frequenz der Anfangsstrahlung verschieden ist. Dabei weist der Konverterresonator einen Aktuator auf, wobei der Aktuator derart angeordnet und eingerichtet ist, dass eine Resonanzfrequenz des Konverterresonators mittels des Aktuators in Abhängigkeit von einem Konversionssteuersignal abstimmbar ist. Der Konversionsdetektor ist in einem Strahlengang der konvertierten Strahlung oder in dem Strahlengang der Anfangsstrahlung in Strahlrichtung nach dem Einkoppelspiegel angeordnet, sodass der Konversionsdetektor in dem Betrieb der Strahlungsquelle ein Maß für die Leistung der konvertierten Strahlung erfasst und ein das Maß für die Leistung der konvertierten Strahlung repräsentierendes Konversionsmesssignal ausgibt. Die Steuerung ist derart mit dem Konversionsdetektor verbunden, dass die Steuerung in dem Betrieb der Strahlungsquelle das Konversionsmesssignal empfängt, wobei die Steuerung derart mit dem Aktuator verbunden ist, dass der Aktuator in dem Betrieb der Strahlungsquelle das Konversionssteuersignal von der Steuerung empfängt. Ferner ist die Steuerung derart eingerichtet, dass sie in dem Betrieb der Strahlungsquelle in einem ersten Betriebsmodus das Konversionssteuersignal in Abhängigkeit von dem Konversionsmesssignal derart erzeugt, dass die Resonanzfrequenz so geregelt ist, dass sie der Signalmittenfrequenz folgt.

Die vorliegende Erfindung betrifft darüber hinaus ein Verfahren zum Erzeugen elektromagnetischer Strahlung mit einer Mehrzahl von Frequenzen, wobei das Verfahren die Schritte aufweist: Erzeugen von elektromagnetischer Anfangsstrahlung mit einer Anfangsmittenfrequenz mit einer Anfangsstrahlungsquelle, Einkoppeln der Anfangsstrahlung durch einen Einkoppelspiegel in einen für die Anfangsstrahlung resonanten Konverterresonator, Erzeugen von konvertierter Strahlung mit einer konvertierten Frequenz aus der Anfangsstrahlung in einem in dem Konverterresonator angeordneten nichtlinear optischen Kristall, wobei die konvertierte Frequenz von einer Frequenz der Anfangsstrahlung verschieden ist, Erfassen eines Maßes für die Leistung der konvertierten Strahlung mit einem in einem Strahlengang der konvertierten Strahlung oder in dem Strahlengang der Anfangsstrahlung in Strahlrichtung nach dem Einkoppelspiegel angeordneten Konversionsdetektor und in einem ersten Betriebsmodus Regeln einer Resonanzfrequenz des Konverterresonators in Abhängigkeit von dem Maßes für die Leistung der konvertierten Strahlung, so dass die Resonanzfrequenz der Anfangsmittenfrequenz folgt.

Aus dem Stand der Technik sind Strahlungsquellen bekannt, die versuchen, eine möglichst große Wellenlängenabdeckung der erzeugten elektromagnetischen Strahlung bereitzustellen. Beispielsweise ist es aus dem Stand der Technik bekannt, einen Pumplaser zum Pumpen eines optisch parametrischen Oszillators zu verwenden, sodass neben der Frequenz der elektromagnetischen Pumpstrahlung auch die Signal- und Idler-Strahlung des optisch parametrischen Oszillators mit von der Frequenz der Pumpstrahlung verschiedener Signal-Mittenfrequenz und Idler-Mittenfrequenz zur Verfügung steht. Eine solche Anordnung aus Pumplaser und optisch parametrischem Oszillator wird im Sinne der vorliegenden Anmeldung als Anfangsquelle bezeichnet. Wird nun, wie ebenfalls aus dem Stand der Technik bekannt, aus der Signal-Strahlung durch einen weiteren nichtlinearen Prozess in einem nichtlinear optischen Frequenzkonverter, beispielsweise durch Generierung der zweiten Harmonischen in einem nichtlinear optischen Kristall, konvertierte Strahlung erzeugt, so kann eine solche Strahlungsquelle vier voneinander verschiedene Wellenlängen adressieren.

Um die erforderliche Leistung auch für die konvertierte Strahlung, welche durch einen nichtlinear optischen Prozess aus der Anfangsstrahlung generiert wird, bereitzustellen, ist für den nichtlinear optischen Frequenzkonverter ein nichtlinear optischer Kristall in einem für die Anfangsstrahlung resonanten Konverterresonator angeordnet. Die Leistung der in dem Frequenzkonverter aus der Anfangsstrahlung generierten konvertierten Strahlung hängt dann von einer Vielzahl von Parametern ab. Ein wesentlicher Faktor ist dabei die Differenz zwischen der Anfangsmittenfrequenz und der Resonanzfrequenz des Konverterresonators. Ändert sich die Anfangsmittenfrequenz, während die Resonanzfrequenz des Konverterresonators konstant bleibt, so ändert sich auch die Leistung der konvertierten Strahlung.

Daher ist es im Stand der Technik etabliert, ein Maß für die Leistung der konvertierten Strahlung zu erfassen und ein dieses Maß repräsentierendes Konversionsmesssignal zum Regeln der Resonanzfrequenz zu nutzen. Auf diese Weise folgt die Resonanzfrequenz der Anfangsmittenfrequenz und die Leistung der konvertierten Strahlung ist zu jedem Zeitpunkt maximiert schwankt aber stark mit der Anfangsmittenfrequenz. Diese Leistungsschwankungen und Drifts liegen typischerweise in der Größenordnung von mehreren Prozent der Gesamtleistung der konvertierten Strahlung.

Für viele Anwendungsfälle einer solchen Strahlungsquelle ist diese aus dem Stand der Technik bekannte Regelung der Resonanzfrequenz ideal, da sie unter gegebenen Bedingungen immer zur maximalen Leistung der konvertierten Strahlung führt. Allerdings gibt es Anwendungen, beispielsweise Verfahren zum Kalibrieren von Messgeräten, die eine stabile, im Wesentlichen zeitlich konstante Leistung benötigen. Dafür nimmt man in Kauf, dass das Leistungsniveau insgesamt niedriger liegt als das Maximum, welches durch die Regelung der Resonanzfrequenz bereitgestellt werden kann. Daher sind aus dem Stand der Technik einem nichtlinear optischen Frequenzkonverter nachgeschaltete Leistungsstabilisierer oder "Noise eater", beispielsweise auf Grundlage von akustooptischen oder elektrooptischen Modulatoren, bekannt. Diese führen zu einer Glättung der Schwankungen der Leistung der konvertierten Strahlung, reduzieren aber insgesamt das Leistungsniveau und erhöhen den apparativen Aufwand.

Daher ist es Aufgabe der vorliegenden Erfindung, eine Strahlungsquelle bereitzustellen, die es ermöglicht, einen breiteren Bereich von Anwendungen für eine solche Strahlungsquelle bereitzustellen. Dabei gilt es, gleichzeitig den apparativen Aufwand so effizient wie möglich zu gestalten.

Die zuvor genannte Aufgabe wird mit einer Strahlungsquelle gemäß dem unabhängigen Anspruch 1 der vorliegenden Anmeldung gelöst.

Dazu ist die Steuerung einer Strahlungsquelle zum Erzeugen elektromagnetischer Strahlung mit einer Mehrzahl von Frequenzen der eingangs genannten Art derart eingerichtet, dass die Steuerung in dem Betrieb der Strahlungsquelle auswählbar zwischen dem ersten Betriebsmodus und einem zweiten Betriebsmodus umschaltbar ist. Dabei ist die Steuerung derart eingerichtet, dass sie in dem zweiten Betriebsmodus das Konversionssteuersignal derart erzeugt, dass die Leistung der konvertierten Strahlung so geregelt ist, dass entweder die Leistung der konvertierten Strahlung eine geringere relative zeitliche Schwankung aufweist als die Leistung der Anfangsstrahlung in der Strahlrichtung vor dem Einkoppelspiegel oder die Leistung der Anfangsstrahlung in der Strahlrichtung nach dem Einkoppelspiegel eine geringere relative zeitliche Schwankung aufweist als die Leistung der Anfangsstrahlung in der Strahlrichtung vordem Einkoppelspiegel.

Es ist die grundlegende Idee der vorliegenden Erfindung, die Strahlungsquelle für einen Benutzer umschaltbar auszugestalten, sodass der Benutzer auswählen kann, ob die Regelung des Frequenzkonverters so erfolgt, dass entweder zu jedem Zeitpunkt die maximale Leistung der konvertierten Strahlung zur Verfügung steht, jedoch zum Preis einer größeren relativen Leistungsschwankung oder aber die konvertierte Strahlung oder die Anfangsstrahlung in Strahlrichtung hinter dem Einkoppelspiegel mit verringerter relativer Leistungsschwankung, jedoch mit geringerer absoluter Leistung zur Verfügung steht. Als Vergleichsmaßstab für die relative zeitliche Schwankung der Leistung entweder der konvertierten Strahlung oder der Anfangsstrahlung in Strahlrichtung hinter dem Einkoppelspiegel dient die Anfangsstrahlung in Strahlrichtung vor dem Einkoppelspiegel, d.h. in Strahlrichtung vor dem Konverterresonator.

Mit der erfindungsgemäßen Lösung lässt sich in dem zweiten Betriebsmoduls wahlweise die relative zeitliche Schwankung der Leistung der konvertierten Strahlung reduzieren oder aber die relative zeitliche Schwankung der Anfangsstrahlung.

Die Leistungsaufnahme an Anfangsstrahlung durch den Frequenzkonverter hängt davon ab, wie groß die tatsächliche Konversion der Anfangsstrahlung in dem Frequenzkonverter in die konvertierte Strahlung ist. Daher lässt sich über eine Regelung der Leistung der konvertierten Strahlung über die Resonanzfrequenz des Konversionsresonators alternativ zur Leistung der konvertierten Strahlung selbst auch eine zeitliche Schwankung der Leistung der von dem Einkoppelspiegel des Konversionsresonators reflektierten Ausgangsstrahlung reduzieren. Der Frequenzkonverter dient dann gewissermaßen als "Noise Eater" für die Ausgangsstrahlung.

In einer Ausführungsform der Erfindung ist der Einkoppelspiegel derart angeordnet, dass die an dem Einkoppelspiegel reflektierte und nicht in den Konverterresonator transmittierte Anfangsstrahlung unter einem von 90° verschiedenen Winkel an dem Einkoppelspiegel reflektiert wird.

Der nichtlinear optische Frequenzkonverter ist in einer Ausführungsform der Erfindung ausgewählt aus einem Frequenzverdoppler, einer Einrichtung zur Summenfrequenzerzeugung, einer Einrichtung zur Differenzfrequenzerzeugung, einer Einrichtung zur Bereitstellung eines optisch parametrischen Prozesses oder einer Einrichtung zum 4-Wellen-Mischen.

In einer Ausführungsform der Erfindung ist der nichtlinear optische Frequenzkonverter ein Frequenzverdoppler, wobei dann der nichtlinear optische Kristall ein Verdopplerkristall ist, so dass die konvertierte Frequenz gleich dem Doppelten der Frequenz der Ausgangsstrahlung ist.

Unabhängig davon, welcher nichtlinear optische Prozess in dem Frequenzkonverter dazu dient, die konvertierte Strahlung zu erzeugen, umfasst der Frequenzkonverter erfindungsgemäß immer einen Konverterresonator, der für die Anfangsstrahlung resonant ist und so zu einer Überhöhung der Konversionseffizienz in dem nichtlinear optischen Kristall führt.

In einer Ausführungsform der Erfindung ist der Einkoppelspiegel, durch den die Anfangsstrahlung in den Konverterresonator eingekoppelt wird, ein für die Anfangsstrahlung teildurchlässiger Spiegel. Ein solcher teildurchlässiger Spiegel führt dazu, dass immer ein Anteil der Anfangsstrahlung an dem Einkoppelspiegel reflektiert wird.

In einer Ausführungsform umfasst die Anfangsquelle einen Pumplaser und einen optisch parametrischen Oszillator, wobei der Pumplaser derart eingerichtet ist, dass er in einem Betrieb der Strahlungsquelle elektromagnetische Pumpstrahlung erzeugt, wobei der optisch parametrische Oszillator (OPO) in einem Strahlengang der Pumpstrahlung angeordnet ist, und wobei der optisch parametrische Oszillator derart eingerichtet ist, dass er in dem Betrieb der Strahlungsquelle Signal-Strahlung mit einer Signal-Mittenfrequenz und Idler-Strahlung aus der Pumpstrahlung erzeugt, so dass die Signal-Strahlung die Anfangsstrahlung ist

Ein optisch parametrischer Oszillator im Sinne der vorliegenden Anmeldung umfasst einen linear optischen OPO-Kristall in einem optischen Resonator. Der Kristall erzeugt in dem Betrieb der Strahlungsquelle aus der von dem Pumplaser erzeugten und in den Resonator eingestrahlten Pumpstrahlung über eine nichtlineare 3-Wellen-Wechselwirkung elektromagnetische Strahlung mit zwei Wellenlängen. In dem OPO erzeugte elektromagnetische Strahlung trägt die Bezeichnung Signal-Strahlung und Idler-Strahlung. Der OPO-Resonator ist zumindest für die Idler-Strahlung oder die Signal-Strahlung resonant. Durch die resonante Überhöhung der Signal-Strahlung oder der Idler-Strahlung in dem OPO erfolgt eine parametrische Verstärkung mit nennenswerter Konversionseffizienz. Aus der Energieerhaltung ergibt sich, dass die Summe der Signal-Frequenzen der Signal-Strahlung und der Idler-Frequenz der Idler-Strahlung gleich einer Pumpfrequenz der Pumpstrahlung ist. Der OPO-Resonator ist zu unterscheiden von dem Konverterresonator des nichtlinear optischen Frequenzkonverters der erfindungsgemäßen Strahlungsquelle.

Im Sinne der vorliegenden Anmeldung werden die Begriffe Signal-Strahlung und Idler-Strahlung zur Bezeichnung der elektromagnetischen Strahlung mit den beiden voneinander verschiedenen Frequenzen bzw. Wellenlängen in dem OPO verwendet. Dies völlig unabhängig davon, ob die Signal-Strahlung eine Signal-Mittenfrequenz aufweist, die größer ist als die Idler-Mittenfrequenz der Idler-Strahlung oder umgekehrt. Dies im Gegensatz zu der an manchen Stellen in der Literatur nachweisbaren Verwendung des Begriffs der Signal-Strahlung für die in dem OPO erzeugte Strahlung mit der höheren Frequenz (kürzeren Wellenlänge).

Der Konversionsdetektor dient dazu, ein Maß für die Leistung der konvertierten Strahlung zu erfassen. Der Konversionsdetektor gibt ein Konversionsmesssignal aus, das dieses Maß für die Leistung der konvertierten Strahlung repräsentiert. Das Konversionsmesssignal wird von der Steuerung für die Regelung des Konverterresonators verwendet.

Ein Maß für die Leistung der konvertierten Strahlung kann an zwei verschiedenen Positionen im Strahlengang der Strahlungsquelle erfasst werden. Zum einen kann der Konversionsdetektor so angeordnet sein, dass er in dem Strahlengang der konvertierten Strahlung angeordnet ist und so unmittelbar die Leistung der konvertierten Strahlung erfasst.

Allerdings ist auch die Leistung der Anfangsstrahlung an einer Position im Strahlengang der Anfangsstrahlung nach einer teilweisen Reflexion an dem Einkoppelspiegel ein Maß für die Leistung der konvertierten Strahlung. Jede Änderung der Leistung der konvertierten Strahlung führt, da die konvertierte Strahlung aus der Anfangsstrahlung entsteht, auch zu einer Leistungsänderung der an dem Einkoppelspiegel teilweise reflektierten Anfangsstrahlung.

Die Steuerung ist in einer Ausführungsform ein Prozessor oder ein Rechner mit einem Prozessor wobei der Prozessor eine entsprechend für die beschriebene Regelung eingerichtete Software abläuft. Allerdings kann die Steuerung in einer Ausführungsform der Erfindung auch als analog-elektronische Regelung ausgestaltet sein.

Erfindungsgemäß ist die Steuerung zwischen zwei Betriebsmodi umschaltbar. In dem ersten Betriebsmodus wird die Resonanzfrequenz des Konverterresonators so geregelt, dass sie der Anfangsmittenfrequenz, mit welcher der Frequenzkonverter gepumpt wird, folgt. Passt die Resonanzfrequenz zur Anfangsmittenfrequenz, so wird bei gegebener Leistung der Anfangsstrahlung die maximale Leistung an konvertierter Strahlung erzeugt.

Geeignete Techniken bzw. Verfahren zum Regeln der Resonanzfrequenz, sodass diese der Anfangsmittenfrequenz folgt, sind ein Verfahren nach Pound-Drever-Hall (PDH-Locking; siehe Eric D. Black "An introduction to Pound-Drever-Hall laser frequency stabilization", Am. J. Phys. 69 (1), Seiten 79 bis 87, Januar 2001), ein Verfahren nach Hänsch-Couillaud (siehe T.W. Hänsch und B. Couillaud "Laser frequency stabilization by polarization spectrocopy of a reflecting reference cavity", Optics Communications, Bd. 35, Nr. 3, Seiten 441 bis 444, Dezember 1980) oder ein Lockin-Verfahren (siehe beispielsweise D.C. Gerstenberger et al. "Efficient scond-harmonic conversion of cw single-frequency Nd:YAG laser light by frequency locking to a monolithic ring frequency doubler", Optics Letters, Bd. 16, Nr. 18, Seiten 992 bis 994; Juli 1991).

In einer Ausführungsform der Erfindung folgt die Regelung der Resonanzfrequenz dem Verfahren nach Pound-Drever-Hall. Daher weist die Strahlungsquelle in einer Ausführungsform einen Modulator auf, wobei der Modulator in dem Strahlengang der Anfangsstrahlung zwischen dem optisch parametrischen Oszillator und dem Einkoppelspiegel des Frequenzkonverters angeordnet ist, wobei der Modulator derart eingerichtet ist, dass er der Anfangsstrahlung eine Phasenmodulation mit einer Modulationsfrequenz aufprägt, und wobei die Steuerung derart eingerichtet ist, dass sie in dem ersten Betriebsmodus die Schritte ausführt
i) Mischen des Konversionsmesssignals mit einem mit der Modulationsfrequenz modulierten Referenzsignal zu einen Mischsignal mit einem nicht-modulierten Term und mit einem mit der zweifachen Modulationsfrequenz modulierten Term,
ii) Filtern des Mischsignals, sodass ein ausschließlich den nicht-modulierten Term enthaltendes Fehlersignal erzeugt wird, und
iii) Erzeugen des Konversionssteuersignals, so dass das Fehlersignal minimal wird.

In einer Ausführungsform der Erfindung stammen ein Modulationssignal mit der Modulationsfrequenz zum Treiben des Modulators und das Referenzsignal, welches ebenfalls mit der Modulationsfrequenz moduliert ist, aus der gleichen Signalquelle, vorzugsweise aber aus der Steuerung.

In einer Ausführungsform der Erfindung ist der Modulator ein elektrooptischer Modulator oder ein photoakustischer Modulator.

In einer Ausführungsform der Erfindung ist der Modulator derart mit der Steuerung verbunden, dass der Modulator in dem Betrieb der Strahlungsquelle ein Modulatorsteuersignal von der Steuerung empfängt, wobei die Steuerung derart eingerichtet ist, dass sie in den Betrieb der Strahlungsquelle in dem ersten Betriebsmodus das Modulatorsteuersignal so erzeugt, dass der Modulator die Anfangsstrahlung wirksam moduliert und in dem zweiten Betriebsmodus das Modulatorsteuersignal so erzeugt, dass der Modulator die Anfangsstrahlung nicht wirksam moduliert. Da die Regelung in dem zweiten Betriebsmodus keine Modulation der Anfangsstrahlung erfordert, kann in dem zweiten Betriebsmodus durch Deaktivieren der Modulation der Anfangsstrahlung eine weitere Reduzierung eines Signalrauschens bewirkt werden.

In einer Ausführungsform der Erfindung verwirklicht die Steuerung in dem zweiten Betriebsmodus ein sogenanntes Side-of-Fringe Locking (SoF Locking). Dazu führt die Steuerung in dem zweiten Betriebsmodus die Schritte aus:
a) Bilden eines Fehlersignals als Differenz zwischen dem Konversionsmesssignal und einem vorgegebenen, konstanten Offsetsignal und
b) Erzeugen des Konversionssteuersignals, sodass das Fehlersignal minimal wird.

Die grundlegende Idee dieses Verfahrens zur Leistungsstabilisierung, so wie es für den zweiten Betriebsmodus verwendet wird, ist es, die Resonanzfrequenz außerhalb der Signalmittenfrequenz zu positionieren. Auf diese Weise kann durch eine Regelung der Resonanzfrequenz dann die Leistung der konvertierten Strahlung stabilisiert werden. Schwankungen nach oben und nach unten um einen definierten Wert für die Leistung herum können durch Ändern der Resonanzfrequenz ausgeglichen werden. Dies ist im Gegensatz dazu nicht der Fall, wenn die Resonanzfrequenz gleich der Anfangsmittenfrequenz ist. Dann kann die Leistung der konvertierten Strahlung lediglich reduziert werden.

Der Aktuator des Konverterresonators dient dazu, die Resonanzfrequenz des Konverterresonators in Abhängigkeit von einem Konversionssteuersignal abzustimmen. Ein solcher Aktuator ist in einer Ausführungsform der Erfindung ein auf einem Linearversteller angeordneten Spiegel, wobei der Linearversteller beispielsweise ein Piezokristall ist. Weitere Beispiele für einen geeigneten Aktuator sind ein elektrooptischer Modulator, ein akustooptischer Modulator oder ein Filter, beispielsweise ein Fabry-Perot-Resonator, die in den Strahlengang des Konverterresonators eingebracht sind, hier insbesondere in den Strahlengang der Signal-Strahlung in dem Konverterresonator, oder ein Heizelement zum Variieren der Temperatur des nichtlinear optischen Kristalls in dem Konverterresonators.

In einer Ausführungsform der Erfindung umfasst die Strahlungsquelle einen Anfangsstrahlungs-Detektor. Der Anfangsstrahlungs-Detektor ist in dem Strahlengang der Anfangsstrahlung vor dem Einkoppelspiegel angeordnet, sodass der Anfangsstrahlungs-Detektor in dem Betrieb der Strahlungsquelle ein Maß für die Leistung der Anfangsstrahlung (vor dem Einkoppelspiegel) erfasst und ein das Maß für die Leistung der Anfangsstrahlung repräsentierendes Anfangsstrahlung-Messsignal ausgibt. Dabei ist die Steuerung derart mit dem Anfangsstrahlung-Detektor verbunden, dass die Steuerung in dem Betrieb der Strahlungsquelle das Anfangsstrahlung-Messsignal empfängt. Die Steuerung ferner derart mit der Anfangsquelle, beispielsweise mit dem Pumplaser, verbunden, dass der Anfangsquelle in dem Betrieb der Strahlungsquelle ein Anfangsstrahlungs-Steuersignal von der Steuerung empfängt, wobei die Steuerung derart eingerichtet ist, dass in dem Betrieb der Strahlungsquelle das Anfangsstrahlungs-Steuersignal in Abhängigkeit von dem Anfangsstrahlungs-Messsignal derart erzeugt, dass eine Anfangsleistung der Anfangsstrahlung, insbesondere eine Pumpleistung der Pumplasers, so geregelt ist, dass die Anfangsleistung im Wesentlichen gleich einer vorgegebenen Soll-Anfangsleistung ist.

Mit einer solchen Ausführungsform der Erfindung wird zusätzlich zu einer Regelung der Leistung entweder der Anfangsstrahlung in Strahlrichtung hinter dem Einkoppelspiegel des Frequenzkonverters oder der konvertierten Strahlung mittels des Frequenzkonverters die Anfangsstrahlung schon vor dem Frequenzkonverter stabilisiert, indem die Leistung der von der Anfangsquelle bereitgestellten Anfangsstrahlung geregelt wird. Dabei kann die Steuerung bzw. Regelung der Leistung der von der anfangsquelle generierten Strahlung mittelbar oder unmittelbar erfolgen. Ein Beispiel für eine mittelbare Steuerung ist die Steuerung des Stroms einer Laserdiode eines Anfangslasers, insbesondere der Laserdiode eines Pumplasers. Eine mittelbare Regelung wird beispielsweise mit Hilfe eines Modulators der Anfangsquelle erzielt.

In einer Ausführungsform ist die Strahlungsquelle derart ausgestaltet, dass der Frequenzkonverter die Anfangsquelle einen Pumplaser und einen OPO aufweist, wobei die Strahlungsquelle in dem Betrieb zumindest zwei aus der konvertierten Strahlung, der Signal-Strahlung, der Idler-Strahlung und der Pumpstrahlung abstrahlt. In einer Ausführungsform der Erfindung strahlt die Strahlungsquelle gleichzeitig oder auswählbar alle vier zuvor genannten Strahlungen ab. Eine derartige Quelle hat ein eine extrem vielseitige Einsetzbarkeit.

Die oben genannte Aufgabe wird zudem durch ein Verfahren gemäß dem hierauf gerichteten unabhängigen Anspruch gelöst. Dazu weist das Verfahren der eingangs genannten Art zusätzlich die Schritte auf: auswählbares Umschalten zwischen dem ersten Betriebsmodus und einem zweiten Betriebsmodus, in dem zweiten Betriebsmodus Regeln der Leistung der konvertierten Strahlung, so dass entweder die Leistung der konvertierten Strahlung eine geringere relative zeitliche Schwankung aufweist als die Leistung der Anfangsstrahlung in der Strahlrichtung vor dem Einkoppelspiegel oder die Leistung der Anfangsstrahlung in der Strahlrichtung nach dem Einkoppelspiegel eine geringere relative zeitliche Schwankung aufweist als die Leistung der Anfangsstrahlung in der Strahlrichtung vor dem Einkoppelspiegel.

Soweit zuvor Aspekte der Erfindung im Hinblick auf die Strahlungsquelle beschrieben wurden, so gelten diese auch für das entsprechende Verfahren zum Erzeugen elektromagnetischer Strahlung mit einer Mehrzahl von Frequenzen und umgekehrt. Soweit das Verfahren mit einer Strahlungsquelle gemäß dieser Erfindung ausgeführt wird, so weist diese die entsprechenden Einrichtungen hierfür auf. Insbesondere aber sind Ausführungsformen der Strahlungsquelle zum Ausführen der hierin beschriebenen Ausführungsformen des Verfahrens geeignet.

Weitere Vorteile, Merkmale und Anwendungsmöglichkeiten der vorliegenden Erfindung werden anhand der folgenden Beschreibung von Ausführungsformen und der dazugehörigen Figuren deutlich. In den Figuren sind gleiche Elemente mit gleichen Bezugszeichen bezeichnet.
- Figur 1: ist ein schematisches Blockschaltbild einer Ausführungsform der erfindungsgemäßen Strahlungsquelle.
- Figur 2: ist eine schematische Darstellung einer zweiten Ausführungsform der erfindungsgemäßen Strahlungsquelle in einem ersten Betriebsmodus.
- Figur 3: ist eine schematische Darstellung der zweiten Ausführungsform der erfindungsgemäßen Strahlungsquelle aus Figur 2 in einem zweiten Betriebsmodus.
- Figur 4: ist eine schematische Darstellung einer weiteren Ausführungsform der erfindungsgemäßen Strahlungsquelle.
- Figur 5: ist eine Auftragung der Leistung der konvertierten Strahlung gegenüber der Zeit, wobei die Strahlungsquelle aus Figuren 2 und 3 in dem ersten Betriebsmodus ist.
- Figur 6: ist eine Auftragung der Leistung der konvertierten Strahlung gegenüber der Zeit, wobei die Strahlungsquelle aus Figuren 2 und 3 in dem zweiten Betriebsmodus ist.

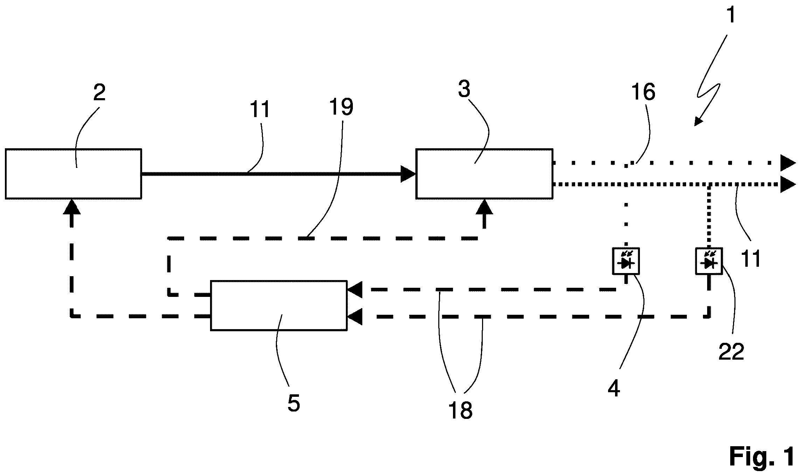

Figur 1 veranschaulicht in einem Blockschaltbild den Grundgedanken einer erfindungsgemäßen Strahlungsquelle 1. Die Strahlungsquelle 1 umfasst eine Anfangsquelle 2, einen Frequenzkonverter 3, einen Konversionsdetektor 4 bzw. 22 und eine Steuerung 5.

Die Anfangsquelle 2 erzeugt eine elektromagnetische Anfangsstrahlung 11 mit einer Anfangsmittenfrequenz. Der Frequenzkonverter umfasst einen für die Anfangsstrahlung 11 resonanten Konverterresonator mit einem für die Anfangsstrahlung 11 teilweise transparenten Einkoppelspiegel und einen in dem Konverterresonator angeordneten nichtlinear optischen Kristall aufweist. Die Anfangsstrahlung 11 wird zum Pumpen des nichtlinear optischen Frequenzkonverters 3 genutzt. Dazu wird die Anfangsstrahlung 11 durch den Einkoppelspiegel in den Konverterresonator eingekoppelt.

Der Frequenzkonverter 3 erzeugt aus der Anfangsstrahlung 11 konvertierte Strahlung 16 mit einer konvertierten Frequenz, wobei die konvertierte Frequenz von einer Frequenz der Anfangsstrahlung 11 verschieden ist. Der Konverterresonator der Frequenzkonverters 3 umfasst einen Aktuator, der zur Abstimmung der Resonanzfrequenz des Konverterresonators in Abhängigkeit von einem Konversionssteuersignal 19 abstimmbar ist.

Ein Konversionsdetektor 4 oder 22 dient dazu ein Maß für die Leistung der konvertierten Strahlung 16 zu erfassen und ein Konversionsmesssignal 18, welches das Maß für die Leistung der konvertierten Strahlung 16 repräsentiert an eine Steuerung 5 auszugeben. Ein Maß für die Leistung der konvertierten Strahlung 16 kann entweder durch Messen der Leistung der konvertierten Strahlung 16 oder durch Messen der Leistung der nicht in dem Frequenzkonverter 3 konvertierten Anfangsstrahlung 11 bestimmt werden. Beide Varianten sind in Figur 1 schematisch dargestellt. Im ersten Fall ist der Konversionsdetektor 4 in einem Strahlengang der konvertierten Strahlung 16 angeordnet. Im zweiten Fall ist der Konversionsdetektor 22 in einem Strahlengang der nicht konvertierten Anfangsstrahlung hinter dem Frequenzkonverter 3 angeordnet.

Die Steuerung 5 ist neben dem Konversionsdetektor 4, 22 auch mit dem Aktuator verbunden, so dass der Aktuator das Konversionssteuersignal 19 von der Steuerung 5 empfängt. Die Steuerung erzeugt in einem ersten Betriebsmodus das Konversionssteuersignal 19 in Abhängigkeit von dem Konversionsmesssignal 18 derart, dass die Resonanzfrequenz so geregelt ist, dass sie der Anfangsmittenfrequenz folgt. Die Steuerung 5 ist auswählbar zwischen dem ersten Betriebsmodus und einem zweiten Betriebsmodus umschaltbar. In dem zweiten Betriebsmodus erzeugt die Steuerung 5 das Konversionssteuersignal 19 derart, dass die Leistung der konvertierten Strahlung 16 so geregelt ist, dass entweder die Leistung der konvertierten Strahlung 16 eine geringere relative zeitliche Schwankung aufweist als die Leistung der Anfangsstrahlung 11 in der Strahlrichtung vor dem Frequenzkonverter bzw. vor dessen Einkoppelspiegel oder die Leistung der Anfangsstrahlung 11 in der Strahlrichtung nach dem Einkoppelspiegel 12 eine geringere relative zeitliche Schwankung aufweist als die Leistung der Anfangsstrahlung 11 in der Strahlrichtung vor dem Einkoppelspiegel.

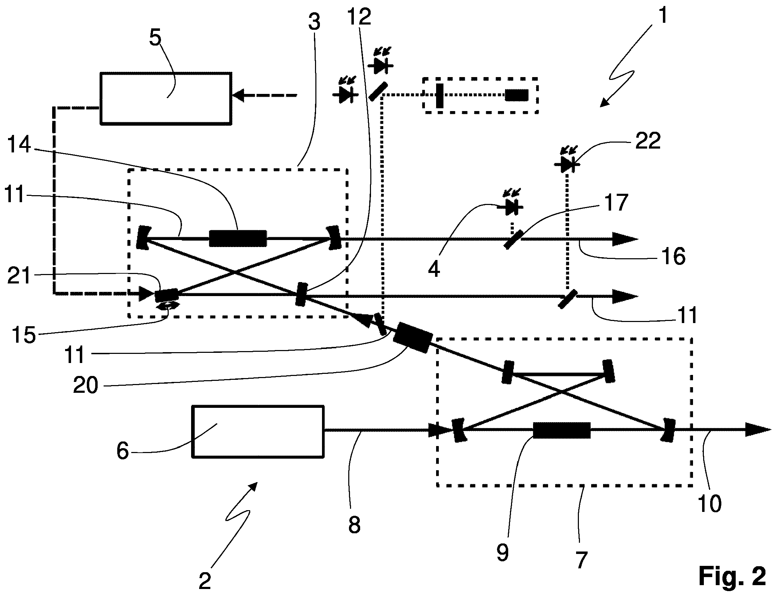

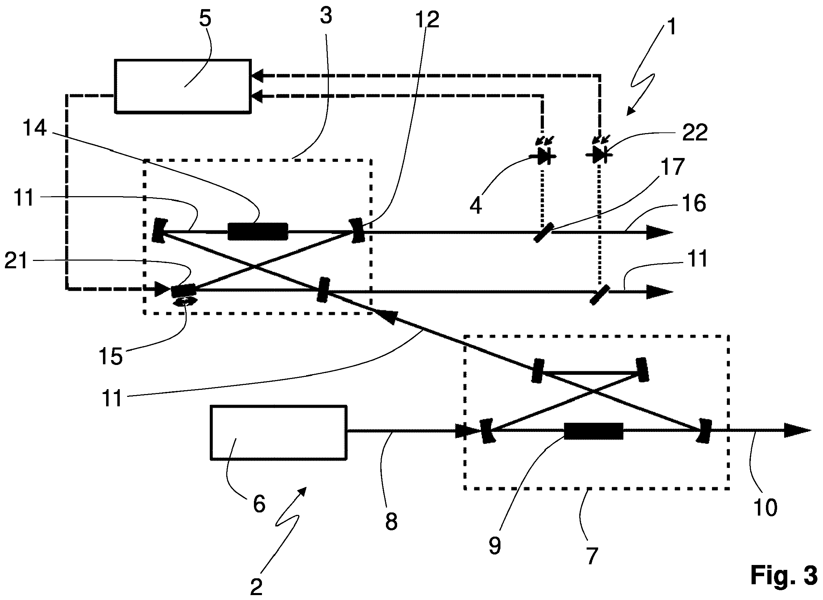

Die Figuren 2 und 3 zeigen eine konkrete Realisierung einer Strahlungsquelle 1 gemäß des Blockschaltbilds aus Figur 1. Die Strahlungsquelle 1 aus Figuren 2 und 3 umfasst wie zuvor eine Anfangsquelle 2, einen Frequenzkonverter 3, einen Konversionsdetektor 4 sowie eine Steuerung 5.

In der konkreten Realisierung setzt sich die Anfangsquelle 2 aus einem Pumplaser 6 und einem optisch parametrischen Oszillator (OPO) 7 zusammen. Dabei erzeugt der Pumplaser 6 Pumpstrahlung 8 mit einer Pumpmittenfrequenz. Die Pumpstrahlung 8 wird in den OPO eingekoppelt und erzeugt dort in einem nichtlinear optischen Kristall 9 Idlerstrahlung 10 und Signalstrahlung 11.

In der dargestellten Ausführungsform wird die Signalstrahlung 11 zum Pumpen eines Frequenzkonverters in Form eines Frequenzverdopplers 3 verwendet. Der Frequenzverdoppler 3 umfasst in der dargestellten Ausführungsform einen als Ringresonator 13 mit vier Spiegeln ausgestalteten Verdopplerresonator. In dem Ringresonator 13 ist ein nichtlinear optischer Verdopplerkristall 14 angeordnet. Der Verdopplerresonator 13 ist resonant für die Signalstrahlung 11, sodass der nichtlinear optische Prozess der Frequenzverdoppelung in den Verdopplerkristall 14 eine Überhöhung erfährt.

Während der mit dem Bezugszeichen 12 bezeichnete Spiegel als Einkoppelspiegel für die Signalstrahlung 11 dient, ist ein weiterer Spiegel 21 auf einem Piezoversteller 15 als Aktuator im Sinne der vorliegenden Anmeldung montiert. Mit Hilfe des Piezoversteller 15 lässt sich die Länge des Resonators 13 und damit die Resonanzfrequenz einstellen und mit Hilfe der Steuerung 5 regeln. In dem Verdopplerkristall 14 wird im Betrieb der Strahlungsquelle 1 im Vergleich zur Signalstrahlung 11 frequenzverdoppelte konvertierte Strahlung 16 aus der Signalstrahlung 11 generiert.

Im Strahlengang der frequenzverdoppelten Strahlung 16 ist ein Strahlteiler 17 angeordnet, über den ein Teil der frequenzverdoppelten Strahlung 16 ausgekoppelt und auf den Konversionsdetektor 4 geleitet wird. Der Konversionsdetektor 4 im Strahlengang der frequenzverdoppelten Strahlung 16 erfasst ein Maß für die Leistung der frequenzverdoppelten Strahlung 16.

Die Steuerung 5 ist nun einerseits derart mit dem Konversionsdetektor 4 verbunden, dass die Steuerung 5 in dem Betrieb der Strahlungsquelle 1 ein Konversionsmesssignal, welches das Maß für die Leistung der frequenzverdoppelten Strahlung 16 repräsentiert, von dem Konversionsdetektor 4 erhält. Andererseits ist die Steuerung 5 mit dem Piezoversteller 15 verbunden, sodass die Steuerung 5 in dem Betrieb ein Konversionssteuersignal 19 von der Steuerung 5 empfängt.

Die Steuerung 5 ermöglicht es einem Benutzer Eigenschaften der frequenzverdoppelten Strahlung 16 im Hinblick auf ihre absolute Leistung und auf die relativen zeitlichen Schwankungen der Leistung auszuwählen.

Die Steuerung 5 ist in der dargestellten Ausführungsform derart programmiert, dass ein Benutzer über eine Benutzerschnittstelle zwischen einem ersten und einem zweiten Betriebsmodus auswählen und die Regelung der Resonatorlänge des Verdopplerresonators 13 zwischen diesen Betriebsmodi umschalten kann. Der erste Betriebsmodus ist in Figur 2 schematisch gezeigt und der zweite Betriebsmodus in Figur 3.

In dem ersten Betriebsmodus erfolgt die Regelung der Resonanzfrequenz mit einem Verfahren nach Pound-Drever-Hall. Zu diesem Zweck ist in der Strahlungsquelle 1 in dem Strahlengang der Signalstrahlung 11 zwischen dem OPO 7 und dem Einkoppelspiegel 12 des Frequenzverdopplers 3 ein elektrooptischer Modulator 20 vorgesehen. Der Modulator 20 ist wiederum so mit der Steuerung 5 verbunden, dass die Steuerung 5 dem Modulator 20 eine Modulationsfrequenz vorgibt, mit welcher der Modulator 20 der Signalstrahlung 11 eine Phasenmodulation aufprägt. Die Steuerung 5 verwendet zudem die Modulationsfrequenz als Referenzfrequenz bei der Regelung der Resonatorlänge.

Ziel der Regelung der Resonatorlänge in dem ersten Betriebsmodus ist es, zu jedem Zeitpunkt die maximal verfügbare Leistung der konvertierten Strahlung 16 zur Verfügung zu stellen, wobei eine größere relative zeitliche Schwankung der Leistung der frequenzverdoppelten Strahlung 16 in Kauf genommen wird.

Verglichen wird die relative zeitliche Schwankung der Leistung der frequenzverdoppelten Strahlung 16 dabei mit der relativen zeitlichen Schwankung der Signalstrahlung 11 vordem Einkoppelspiegel 12, beispielsweise dort, wo die Bezugszeichenlinie des Bezugszeichens 11 in Figur 2 auf die Signalstrahlung 11 zeigt.

In dem ersten Betriebsmodus mischt die Steuerung das Konversionsmesssignal 18 mit dem Referenzsignal zu einen Mischsignal mit einem nicht-modulierten (DC-)Term und mit einem mit der zweifachen Modulationsfrequenz modulierten Term. Aus diesem Mischsignal lässt sich auf einfache Weise der DC-Term herausfiltern. Dieser wird als Fehlersignal der Regelung der Resonatorlänge verwendet. Das Konversionssteuersignal 19 wird so generiert, dass das Fehlersignal minimal wird.

Die Resonatorlänge folgt nun jeder Änderung der Mittenfrequenz der Signalstrahlung 11 und die Leistung der frequenzverdoppelten Strahlung 16 ist im Wesentlichen immer gleich der maximal möglichen Ausgangsleitung der Frequenzverdopplers 3, unterliegt allerdings vergleichsweise großen relativen zeitlichen Schwankungen.

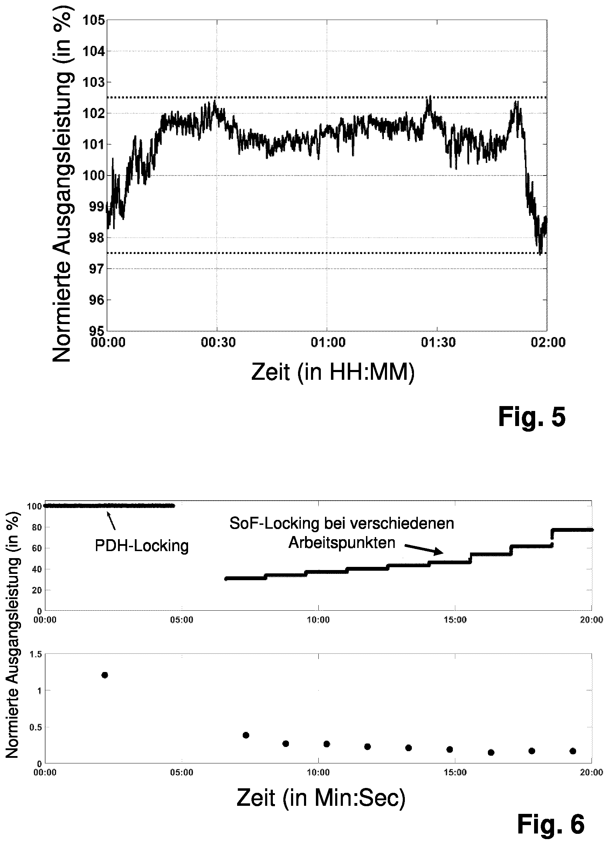

Der zeitliche Verlauf der Leistung der frequenzverdoppelten Strahlung 16 aus der Strahlungsquelle aus Figuren 2 und 3 ist für den ersten Betriebsmodus aus Figur 2 beispielhaft in dem Graphen aus Figur 5 dargestellt.

Bei dem Umschalten in den zweiten Betriebsmodus wird der Modulator 20 über das Modulatorsteuersignal 21 von der Steuerung 5 ausgeschaltet, da die Regelung in dem zweiten Betriebsmodus keine Phasenmodulation der Signalstrahlung 11 erfordert. Dieser zweite Betriebsmodus ist schematisch in Figur 3 dargestellt, in Figur 3 ist der Modulator 20 nicht gezeigt.

Ziel des zweiten Betriebsmodus ist es, die frequenzverdoppelte Strahlung 16 mit verringerter relativer Leistungsschwankung zur Verfügung zu stellen. Dies jedoch mit geringerer absoluter Leistung. Zu diesem Zweck führt die Steuerung 5 in dem zweiten Betriebsmodus ein sogenanntes Side-of-Fringe Locking aus. Dazu bildet die Steuerung 5 ein Fehlersignal als Differenz zwischen dem Konversionsmesssignal 18 und einem vorgegebenen, konstanten Offsetsignal. Das Konversionssteuersignal 19 wird so erzeugt, dass das Fehlersignal minimal wird.

Der zeitliche Verlauf der Leistung der frequenzverdoppelten Strahlung 16 aus der Strahlungsquelle aus Figuren 2 und 3 ist für den zweiten Betriebsmodus auf Figur 3 beispielhaft in dem Graphen aus Figur 6 dargestellt.

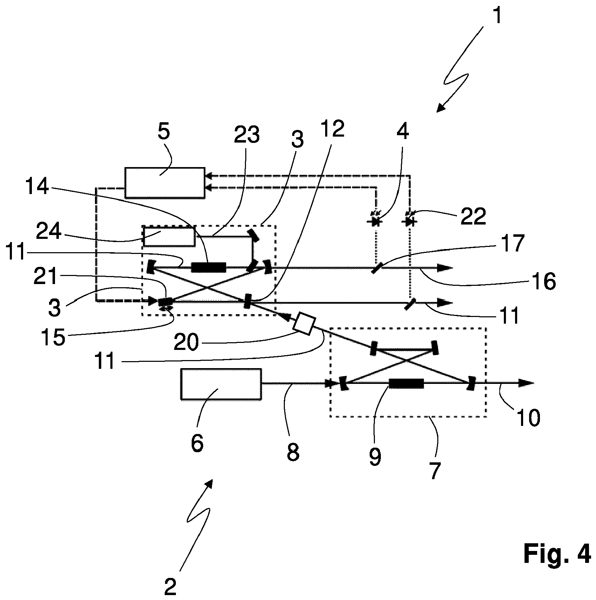

Figur 4 zeigt eine alternative Ausführungsform der Strahlungsquelle 1. Die Strahlungsquelle 1 aus Figur 4 unterscheidet sich von der Strahlungsquelle aus den Figuren 2 und 3 dadurch, dass der Frequenzkonverter 3 statt von einem Frequenzverdoppler von einem Summen- oder Differenzfrequenzgenerator gebildet ist. Der Kristall 14 ist so gewählt, dass in dem Kristall aus der Signal-Strahlung 11 und der Mischstrahlung 23 eines Mischlasers 24 konvertierte Strahlung mit der Summen- oder Differenzfrequenz der Frequenzen der Signal-Strahlung 11 und der Mischstrahlung 23 generiert wird. Auch die Anordnung aus Figur 4 kann wie zuvor für die Anordnung aus Figuren 2 und 3 beschrieben zwischen dem ersten und dem zweiten Betriebsmodus umgeschaltet werden.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente oder Schritte aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

### Bezugszeichenliste

- 1: Strahlungsquelle
- 2: Anfangsquelle
- 3: Frequenzkonverter
- 4: Konversionsdetektor
- 5: Steuerung
- 6: Pumplaser
- 7: Optisch parametrischer Oszillator
- 8: Pumpstrahlung
- 9: nichtlinear optischer Kristall des optisch parametrischen Oszillators 7
- 10: Idler-Strahlung
- 11: Signal-Strahlung
- 12: Einkoppelspiegel
- 13: Resonator des Frequenzkonverters 3
- 14: nichtlinear optischer Kristall des Frequenzkonverters 3
- 15: Piezoversteller
- 16: konvertierte Strahlung
- 17: Strahlteiler
- 18: Konversionsmesssignal
- 19: Konversionssteuersignal
- 20: elektrooptischer Modulator
- 21: Spiegel
- 22: Signal-Strahlungsdetektor
- 23: Mischstrahlung
- 24: Mischlaser

## Patentansprüche

1. Strahlungsquelle (1) zum Erzeugen elektromagnetischer Strahlung (8, 10, 11, 16) mit einer Mehrzahl von Frequenzen, wobei die Strahlungsquelle (1) aufweist
eine Anfangsquelle (2),
wobei die Anfangsquelle (2) derart eingerichtet ist, dass sie in einem Betrieb der Strahlungsquelle (1) eine elektromagnetische Anfangsstrahlung (11) mit einer Anfangsmittenfrequenz erzeugt,
einen nichtlinear optischen Frequenzkonverter (3),
wobei der Frequenzkonverter (3) einen für die Anfangsstrahlung (11) resonanten Konverterresonator (13) mit einem für die Anfangsstrahlung (11) teilweise transparenten Einkoppelspiegel (12) und einen in dem Konverterresonator (13) angeordneten nichtlinear optischen Kristall (14) aufweist,
wobei der Frequenzkonverter (3) in einem Strahlengang der Anfangsstrahlung (11) angeordnet ist, so dass in dem Betrieb der Strahlungsquelle (1) die Anfangsstrahlung (11) durch den Einkoppelspiegel (12) in den Konverterresonator (13) eingekoppelt wird,
wobei der Frequenzkonverter (3) derart eingerichtet ist, dass er in dem Betrieb der Strahlungsquelle (1) aus der Anfangsstrahlung (11) konvertierte Strahlung (16) mit einer konvertierten Frequenz erzeugt, wobei die konvertierte Frequenz von einer Frequenz der Anfangsstrahlung (11) verschieden ist,
wobei der Konverterresonator (13) einen Aktuator (15) aufweist, und wobei der Aktuator (15) derart angeordnet und eingerichtet ist, dass eine Resonanzfrequenz des Konverterresonators (13) mittels des Aktuators (15) in Abhängigkeit von einem Konversionssteuersignal (19) abstimmbar ist,
einen Konversionsdetektor (4),
wobei der Konversionsdetektor (4) in einem Strahlengang der konvertierten Strahlung (16) oder in dem Strahlengang der Anfangsstrahlung in Strahlrichtung nach dem Einkoppelspiegel (12) angeordnet ist, so dass der Konversionsdetektor (4) in dem Betrieb der Strahlungsquelle (1) ein Maß für die Leistung der konvertierten Strahlung (16) erfasst und ein das Maß für die Leistung der konvertierten Strahlung (16) repräsentierendes Konversionsmesssignal (18) ausgibt, und
eine Steuerung (5),
wobei die Steuerung (5) derart mit dem Konversionsdetektor (4) verbunden ist, dass die Steuerung (5) in dem Betrieb der Strahlungsquelle (1) das Konversionsmesssignal (18) empfängt,
wobei die Steuerung (5) derart mit dem Aktuator (15) verbunden ist, dass der Aktuator (15) in dem Betrieb der Strahlungsquelle (1) das Konversionssteuersignal (19) von der Steuerung (5) empfängt, und
wobei die Steuerung (5) derart eingerichtet ist, dass sie in dem Betrieb der Strahlungsquelle (1) in einem ersten Betriebsmodus das Konversionssteuersignal (19) in Abhängigkeit von dem Konversionsmesssignal (18) derart erzeugt, dass die Resonanzfrequenz so geregelt ist, dass sie der Anfangsmittenfrequenz folgt,
**dadurch gekennzeichnet, dass**
die Steuerung (5) derart eingerichtet ist, dass
die Steuerung (5) in dem Betrieb der Strahlungsquelle (1) auswählbar zwischen dem ersten Betriebsmodus und einem zweiten Betriebsmodus umschaltbar ist,
wobei die Steuerung (5) derart eingerichtet ist, dass sie in dem zweiten Betriebsmodus das Konversionssteuersignal (19) derart erzeugt, dass die Leistung der konvertierten Strahlung (16) so geregelt ist, dass entweder die Leistung der konvertierten Strahlung (16) eine geringere relative zeitliche Schwankung aufweist als die Leistung der Anfangsstrahlung (11) in der Strahlrichtung vor dem Einkoppelspiegel (12) oder die Leistung der Anfangsstrahlung (11) in der Strahlrichtung nach dem Einkoppelspiegel (12) eine geringere relative zeitliche Schwankung aufweist als die Leistung der Anfangsstrahlung (11) in der Strahlrichtung vordem Einkoppelspiegel (12).

2. Strahlungsquelle (1) nach dem vorhergehenden Anspruch, wobei Frequenzkonverter ein Frequenzverdoppler (3) ist, wobei der nichtlinear optische Kristall ein Verdopplerkristall (14) ist, so dass die konvertierte Frequenz gleich dem Doppelten der Frequenz der Signalstrahlung (11) ist.

3. Strahlungsquelle (1) nach einem der vorhergehenden Ansprüche, wobei die Anfangsquelle (2) einen Pumplaser (6) und einen optisch parametrischen Oszillator (7) umfasst,
wobei der Pumplaser (6) derart eingerichtet ist, dass er in einem Betrieb der Strahlungsquelle (1) elektromagnetische Pumpstrahlung (8) erzeugt,
wobei der optisch parametrische Oszillator (7) in einem Strahlengang der Pumpstrahlung (8) angeordnet ist, und
wobei der optisch parametrische Oszillator (7) derart eingerichtet ist, dass er in dem Betrieb der Strahlungsquelle (1) Signal-Strahlung (11) mit einer Signal-Mittenfrequenz und Idler-Strahlung (10) aus der Pumpstrahlung (8) erzeugt, so dass die Signal-Strahlung (11) die Anfangsstrahlung ist.

4. Strahlungsquelle (1) nach dem vorhergehenden Anspruch, wobei die Steuerung (5) derart eingerichtet ist, dass sie in dem zweiten Betriebsmodus die Schritte ausführt
a) Bilden eines Fehlersignals als Differenz zwischen dem Konversionsmesssignal (18) und einem vorgegebenen, konstanten Offsetsignal und
b) Erzeugen des Konversionssteuersignals (19), so dass das Fehlersignal minimal wird.

5. Strahlungsquelle (1) nach einem der vorhergehenden Ansprüche, wobei die Strahlungsquelle (1) einen Modulator (20) aufweist
wobei der Modulator (20) in dem Strahlengang der Anfangsstrahlung (11) zwischen dem optisch parametrischen Oszillator (7) und dem Frequenzkonverter (3) angeordnet ist,
wobei der Modulator (20) derart eingerichtet ist, dass er der Anfangsstrahlung (11) eine Phasenmodulation mit einer Modulationsfrequenz aufprägt, und wobei die Steuerung (5) derart eingerichtet ist, dass sie in dem ersten Betriebsmodus die Schritte ausführt
i) Mischen des Konversionsmesssignals (18) mit einem mit der Modulationsfrequenz modulierten Referenzsignal zu einem Mischsignal mit einem nicht-modulierten Term und mit einem mit der zweifachen Modulationsfrequenz modulierten Term,
ii) Filtern des Mischsignals, so dass ein ausschließlich den nicht-modulierten Term enthaltendes Fehlersignal erzeugt wird, und
iii) Erzeugen des Konversionssteuersignals (19), so dass das Fehlersignal minimal wird.

6. Strahlungsquelle (1) nach dem vorhergehenden Anspruch,
wobei der Modulator (20) derart mit der Steuerung (5) verbunden ist, dass der Modulator (20) in dem Betrieb der Strahlungsquelle (1) ein Modulatorsteuersignal von der Steuerung empfängt, und
wobei die Steuerung (5) derart eingerichtet ist, dass sie in dem Betrieb der Strahlungsquelle (1) in dem ersten Betriebsmodus das Modulatorsteuersignal so erzeugt, dass der Modulator (20) die Anfangsstrahlung (11) moduliert, und in dem zweiten Betriebsmodus das Modulatorsteuersignal so erzeugt, dass der Modulator (20) die Anfangsstrahlung (11) nicht moduliert.

7. Strahlungsquelle (1) nach einem der vorhergehenden Ansprüche, wobei die Strahlungsquelle (1) einen Anfangsstrahlungs-Detektor (22) aufweist,
wobei der Anfangsstrahlungs-Detektor (22) in dem Strahlengang der Anfangsstrahlung (11) in der Strahlrichtung vor dem Einkoppelspiegel (12) angeordnet ist, so dass der Anfangsstrahlungs-Detektor (22) in dem Betrieb der Strahlungsquelle (1) ein Maß für die Leistung der Anfangsstrahlung (11) erfasst und ein das Maß für die Leistung der Anfangsstrahlung (11) repräsentierendes Anfangsstrahlungs-Messsignal ausgibt,
wobei die Steuerung (5) derart mit dem Anfangsstrahlungs-Detektor (22) verbunden ist, dass die Steuerung (5) in dem Betrieb der Strahlungsquelle (1) das Anfangsstrahlungs-Messsignal empfängt,
wobei die Steuerung (5) derart mit der Anfangsquelle (2) verbunden ist, dass die Anfangsquelle (2) in dem Betrieb der Strahlungsquelle (1) ein Anfangsstrahlungs-Steuersignal von der Steuerung (5) empfängt, und
wobei die Steuerung (5) derart eingerichtet ist, dass sie in dem Betrieb der Strahlungsquelle (1) das Anfangsstrahlungs-Steuersignal in Abhängigkeit von dem Anfangsstrahlungs-Messsignal derart erzeugt, dass eine Leistung der Anfangsstrahlung (11) so geregelt ist, dass die Leistung im Wesentlichen gleich einer vorgegebenen Soll-Leistung ist.

8. Strahlungsquelle (1) nach dem vorhergehenden Anspruch soweit von Anspruch 3 abhängig, wobei die Steuerung (5) derart mit der Pumplaser (6) verbunden ist, dass der Pumplaser (6) in dem Betrieb der Strahlungsquelle (1) das Anfangsstrahlungs-Steuersignal von der Steuerung (5) empfängt, und wobei die Steuerung (5) derart eingerichtet ist, dass sie in dem Betrieb der Strahlungsquelle (1) das Anfangsstrahlungs-Steuersignal in Abhängigkeit von dem Anfangsstrahlungs-Messsignal derart erzeugt, dass eine Pumpleistung der Pumpstrahlung (8) so geregelt ist, dass die Pumpleistung im Wesentlichen gleich einer vorgegebenen Soll-Pumpleistung ist.

9. Strahlungsquelle (1) nach einem der vorhergehenden Ansprüche soweit von Anspruch 3 abhängig, wobei Strahlungsquelle (1) derart ausgestaltet ist, dass sie in dem Betrieb zumindest zwei Strahlungen ausgewählt aus der konvertierten Strahlung (16) der Signal-Strahlung (11) oder der Idler-Strahlung (10) oder der Pumpstrahlung (8) abstrahlt.

10. Verfahren zum Erzeugen elektromagnetischer Strahlung (8, 10, 11, 16) mit einer Mehrzahl von Frequenzen, wobei das Verfahren die Schritte aufweist
Erzeugen von elektromagnetischer Anfangsstrahlung (11) mit einer Anfangsmittenfrequenz mit einer Anfangsstrahlungsquelle (1),
Einkoppeln der Anfangsstrahlung (11) durch einen Einkoppelspiegel (12) in einen für die Anfangsstrahlung (11) resonanten Konverterresonator (13),
Erzeugen von konvertierter Strahlung (16) mit einer konvertierten Frequenz aus der Anfangsstrahlung (11) in einem in dem Konverterresonator (13) angeordneten nichtlinear optischen Kristall (14), wobei die konvertierte Frequenz von einer Frequenz der Anfangsstrahlung (11) verschieden ist,
Erfassen eines Maßes für die Leistung der konvertierten Strahlung (16) mit einem in einem Strahlengang der konvertierten Strahlung (16) oder in dem Strahlengang der Anfangsstrahlung in Strahlrichtung nach dem Einkoppelspiegel (12) angeordneten Konversionsdetektor (4) und
in einem ersten Betriebsmodus Regeln einer Resonanzfrequenz des Konverterresonators (13) in Abhängigkeit von dem Maßes für die Leistung der konvertierten Strahlung (16), so dass die Resonanzfrequenz der Anfangsmittenfrequenz folgt,
**dadurch gekennzeichnet, dass** Verfahren weiterhin die Schritte aufweist
auswählbares Umschalten zwischen dem ersten Betriebsmodus und einem zweiten Betriebsmodus,
in dem zweiten Betriebsmodus Regeln der Leistung der konvertierten Strahlung (16), so dass entweder die Leistung der konvertierten Strahlung (16) eine geringere relative zeitliche Schwankung aufweist als die Leistung der Anfangsstrahlung (11) in der Strahlrichtung vor dem Einkoppelspiegel (12) oder die Leistung der Anfangsstrahlung (11) in der Strahlrichtung (11) nach dem Einkoppelspiegel (12) eine geringere relative zeitliche Schwankung aufweist als die Leistung der Anfangsstrahlung (11) in der Strahlrichtung vor dem Einkoppelspiegel (12).
